# EUROPEAN PATENT APPLICATION

(11) **EP 3 866 168 A1**
(43) Date of publication of application: **18.08.2021**
(21) Application number: 20315019.8
(22) Date of filing: 12.02.2020
(51) Int. Cl.: G11C 11/16

(54) **MAGNETIC MEMORY CELL WRITABLE IN A DETERMINISTIC FASHION AND METHOD FOR MANUFACTURING SUCH CELL**

(71) Applicant: Antaios, 38240 Meylan (FR)
(72) Inventor: Drouard, Marc, 26000 Valence (FR); Martin, Sylvain, 38100 Grenoble (FR); Kula, Witold, Gilroy, CA 95020 (US)
(74) Representative: P&TS SA (AG, Ltd.)

(57) **Abstract**

A magnetic random access memory (MRAM) cell (100), comprising: a magnetic tunnel junction (MTJ) element (20) comprising a first ferromagnetic layer (21) having a fixed magnetization (210), a tunnel barrier layer (22) and a second ferromagnetic layer (23) having a free magnetization (230); a current layer (30) extending in a plane substantially parallel to the MTJ element (20) and configured for passing a writing current (31) for switching the free magnetization (230); a bias layer (40) configured to generate a magnetic bias field (61) allowing to deterministically switch the free magnetization (230) from a first to a second magnetization state when the writing current (31) is passed; and a non-magnetic, electrically insulating layer (50) between the bias layer (40) and the MTJ element (20), the insulating layer (50) comprising a solid phase materials having a resistivity above 5 x 10⁻⁵ Ω m and a thickness between 0.5 and 50 nm, such that direct exchange coupling between the second magnetization (230) and the bias layer (40) is prevented.

## Description

### Field

The present invention concerns an magnetic memory cell that can be written in a deterministic fashion, and a method for manufacturing said magnetic memory cell.

### Description of related art

A conventional magnetic random-access memory (MRAM) element comprises a magnetic tunnel junction (MTJ) element including a tunnel barrier layer sandwiched between a pinned ferromagnetic layer having a pinned magnetization, and a free ferromagnetic layer having a free magnetization. The MRAM element further comprises an electrically conductive line extending substantially parallel to the plane of the layers and contacting the MTJ element on the side of the free layer. The electrically conductive line is configured for passing a writing current adapted for switching the free magnetization by a spin orbit torque (SOT) interaction. In particular, the writing current exerts a torque on the free magnetization, through for example spin Hall effect and/or Rashba-Edelstein effect, so that the orientation of the free magnetization change, for example, from being parallel to antiparallel to the pinned magnetization.

However, in some cases, including a practically important case of the free layer magnetization being perpendicular to the writing current plane, the spin orbit torques generated by the writing current do not allow for a deterministic switching as both magnetic orientations of the free magnetization are symmetrical for these torques and none of these two magnetic orientations are favored. In order to establish a determined switched orientation of the free magnetization, an additional symmetry-breaking factor is required, such as an additional external magnetic field being at least partly aligned in the direction of the writing current.

### Summary

The present disclosure concerns a magnetic random access memory (MRAM) cell, comprising: a magnetic tunnel junction (MTJ) element comprising a first ferromagnetic layer having a fixed magnetization, a tunnel barrier layer and a second ferromagnetic layer having a free magnetization; a current layer extending in a plane substantially parallel to the MTJ element and configured for passing a writing current for switching the free magnetization by a spin orbit torque (SOT) interaction; a bias layer configured to generate a magnetic bias field interacting with the free magnetization such that the free magnetization is deterministically switchable from a first to a second magnetization state when the writing current is passed; the MRAM cell comprising a non-magnetic, electrically insulating layer between the bias layer and the MTJ element, the insulating layer comprising a solid phase material having a resistivity above 10⁻⁵ Ω m and having a thickness between 0.5 and 50 nm such that direct exchange coupling between the second magnetization and the bias layer is prevented.

The present disclosure concerns a method for manufacturing the MRAM cell, comprising:
forming the current layer and forming the MTJ element comprising the first ferromagnetic layer, tunnel barrier layer, second ferromagnetic layer and a capping layer;
forming the insulating layer such as to cover the current layer and the MTJ element;
forming the bias layer over the insulating layer;
exposing at least a portion of the capping layer; and providing an electrical connector on the exposed portion of the capping layer.

The MRAM cell disclosed herein provides a magnetically bias field biasing the free magnetization such that the symmetry of SOT induced switching is broken and the MRAM cell can be written in a deterministic fashion.

### Brief Description of the Drawings

The invention will be better understood with the aid of the description of an embodiment given by way of example and illustrated by the figures, in which:
Fig. 1 shows a cross section view of a MRAM cell comprising a MTJ element, a current line and a bias layer separated from the MTJ element by a spacer, according to an embodiment;
Fig. 2 shows the MRAM cell whereby the spacer is further arranged between the bias layer and the current line, according to another embodiment;
Fig. 3 shows the MRAM cell whereby the bias layer is arranged on two opposite sides of the MTJ element, according to another embodiment;
Fig. 4 illustrates an arrangement of the bias layer, according to another embodiment;
Fig. 5 shows the MRAM cell whereby the bias layer extends along a sidewall portion of the MTJ element, according to an embodiment;
Fig. 6 represents the bias layer comprising a stack including several layers of magnetic and non magnetic material, according to an embodiment;
Fig. 7 shows the a reversed configuration of the MRAM cell of Fig. 3;
Figs. 8 to 15 illustrate a method for manufacturing the MRAM cell.

### Detailed Description of possible embodiments

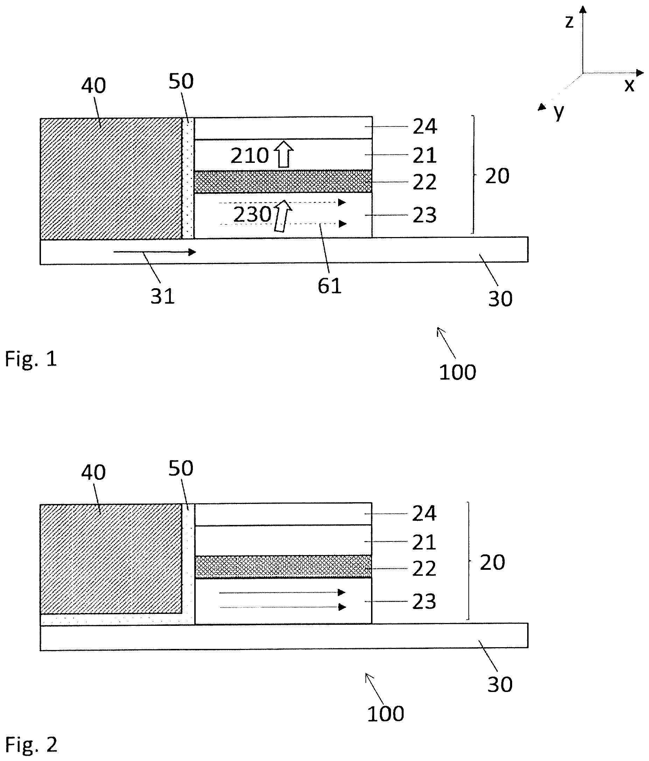

**Fig. 1** shows a cross section view of a MRAM cell 100, according to an embodiment. The MRAM cell 100 comprises an MTJ element 20 comprising a first ferromagnetic layer 21 having a fixed (or reference) magnetization 210, a tunnel barrier layer 22 and a second ferromagnetic layer 23 having a free (or sense) magnetization 230 that can rotate between one of two orientations. A current layer 30 extends in a plane substantially parallel to the MTJ element 20 and is configured for passing a writing current 31 for switching the free magnetization 230. The MRAM cell 100 further comprises a bias layer 40 configured to generate a magnetic bias field 61 to allow deterministically switching the free magnetization 230 from a first to a second magnetization state when the writing current 31 is passed.

The first ferromagnetic layer 21 and the second ferromagnetic layer 23 have perpendicular anisotropy (perpendicular to the plane of the second ferromagnetic layer 23 or out-of-plane).

The MTJ element 20 can comprise a capping layer 24 contacting the MTJ element on the side of the first ferromagnetic layer 21. The capping layer 24 can be electrically conductive layer used as an electrode. The MTJ element 20 can further comprises an antiferromagnetic layer (not shown) exchange coupling the fixed magnetization 210 such as to pin it in a particular direction.

The bias layer 40 is arranged on one side of the MTJ element 20 and is configured to generate a magnetic bias field 61 that has at least a component along the direction of the writing current 31. The writing current 31 flows substantially parallel to the current layer 30 in the direction illustrated in Fig. 1 or in the opposed direction. The magnetic bias field 61 biases the free magnetization 230 such that the free magnetization 230 is tilted from the out-of-plane orientation (along the z axis in Fig. 1) to an orientation slightly towards an in-plane orientation (towards the XY plane in Fig. 1).

During a write operation, passing the writing current 31 in the current line 30 can switch the free magnetization 230 is rotated to an out-of-plane switched orientation. During the write operation, passing a writing current 31 in the current line can switch the free magnetization 230 from one orientation to the other. The writing current 31 allows for deterministically switching the free magnetization 230 direction between a first direction (first polarization state) to a second direction (second polarization state). Depending on the polarity of the writing current 31, the second polarization state can be switched substantially parallel to the reference magnetization 210 or substantially antiparallel to the reference magnetization 210. More particularly, a major component of the free magnetization 230 (along the z axis in Fig. 1) is oriented parallel or antiparallel to the reference magnetization 210, and a minor component of the free magnetization 230 (along the x axis in Fig. 1) is oriented along the direction of the magnetic bias field 61.

The bias layer 40 allows to avoid using an external magnetic field to obtain a deterministic switching of the free magnetization 230. To that end, the bias layer 40 is configured to provide a magnetic bias field 61 that is high enough to break the symmetry and allow deterministic switching. The bias layer 40 can be initialized, i.e., magnetized in a predetermined direction such that the generated magnetic bias field 61 biases the free magnetization 230 in the predetermined direction. The bias layer 40 can be configured to generate a magnetic bias field 61 between a few hundred to few thousand Oe. Namely, the bias layer 40 can be configured to generate a magnetic bias field 61 between 100 Oe and 5000 Oe, or between 200 Oe and 2000 Oe. Moreover, the bias layer 40 can be configured to have sufficient coercivity, typically a few thousand Oe, to keep the orientation of the generated magnetic bias field 61 immune to external magnetic disturbance.

In one aspect, the bias layer 40 is made from a hard magnet (or permanent magnet). The bias layer 40 can be made of any one or a combination of: Co, Fe, CoFe, Ni, NiFe, CoNi, CoPt, CoCrPt, CoCrTa, CoSm. The bias layer 40 can be further made of electrically insulating or dielectric materials.

The MRAM cell 100 further comprises a non-magnetic, electrically insulating spacer 50 between the bias layer 40 and the MTJ element 20. The insulating spacer 50 comprising solid phase materials having a resistivity above 10⁻⁵ Ω m. The insulating spacer 50 further has a thickness such that direct exchange coupling between the free magnetization 230 and the bias layer 40 is prevented.

In an embodiment, the thickness of the insulating spacer 50 is between 0.5 and 50 nm. Preferably, the thickness of the insulating spacer 50 is between 5 and 20 nm or between 1 and 15 nm. Such thicknesses are small enough to have a strong magnetic field on the second ferromagnetic layer 23 and large enough to be electrically insulating. The thin spacer 50 allows to have the bias layer 40 close to the MTJ element 20.

Advantageously, the spacer 50 has good heat dissipation. For example, the spacer 50 can have heat dissipation at least 10 times better than air. For example, the spacer 50 can have a thermal conductivity greater than 0.3 W/(m·K) or greater than 1 W/(m·K). Such thermal conductivity allows for reducing more effectively the heat generated by the writing current 31 better than other insulators, including air.

In an embodiment, the insulating spacer 50 comprises any one or a combination of insulating or dielectric material, such as: SiN, AlO₂, HFO₂, Al₂O₃.

In Fig. 1, the insulating spacer 50 is arranged between the bias layer 40 and the MTJ element 20 such that the MTJ element 20 is not short circuited with the bias layer 40. **Fig. 2** shows an embodiment of the MRAM cell 100, whereby the insulating spacer 50 is further arranged between the bias layer 40 and the current line 30 such that the non-magnetic insulating spacer 50 further avoids any shunting and/or current leakage between the bias layer 40 and the current line 30. The insulating spacer 50 can further protect the MTJ element 20 and current line 30 against corrosion or oxidation.

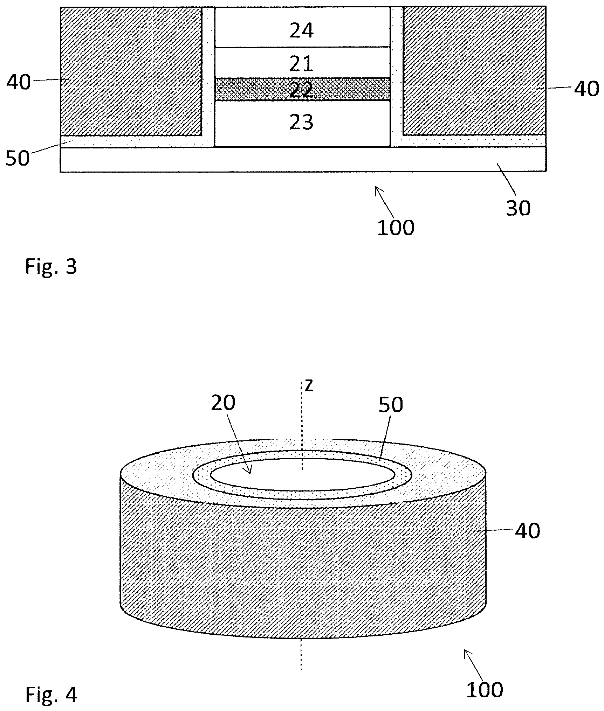

**Fig. 3** shows the MRAM cell 100 according to another embodiment, whereby the bias layer 40 is arranged on two opposite sides of the MTJ element 20. The insulating spacer 50 is arranged between the bias layer 40, the MTJ element 20 and the current line 30.

The bias layer 40 can have any shape. For example, the bias layer 40 can have at least one side having a shape conformal to the shape of the MTJ element 20. In one aspect illustrated in the perspective view of Fig. **4****,** the bias layer 40 extends around the perimeter of the MTJ element 20. In a further configuration not illustrated, the bias layer 40 can extend along a portion of the MTJ element 20 perimeter.

In the examples of Figs. 1 to 4, the thickness of the bias layer 40 (and the height of the insulating spacer 50) corresponds substantially to the height of the MTJ element 20. Since the magnetic bias field 61 is destined to radiate mostly in the second ferromagnetic layer 23, the bias layer 40 can be positioned principally in the area of the second ferromagnetic layer 23. In one aspect, the thickness of the bias layer 40 coincides substantially to the thickness of the second ferromagnetic layer 23, such that the bias layer 40 (and the insulating spacer 50) substantially encapsulates the periphery of the second ferromagnetic layer 23. Other thicknesses of the bias layer 40 are also contemplated. For example, the thicknesses of the bias layer 40 can be greater than the height of the MTJ element 20. Alternatively, the bias layer 40 can have a thickness between the thickness of the second ferromagnetic layer 23 and the height of the MTJ element 20.

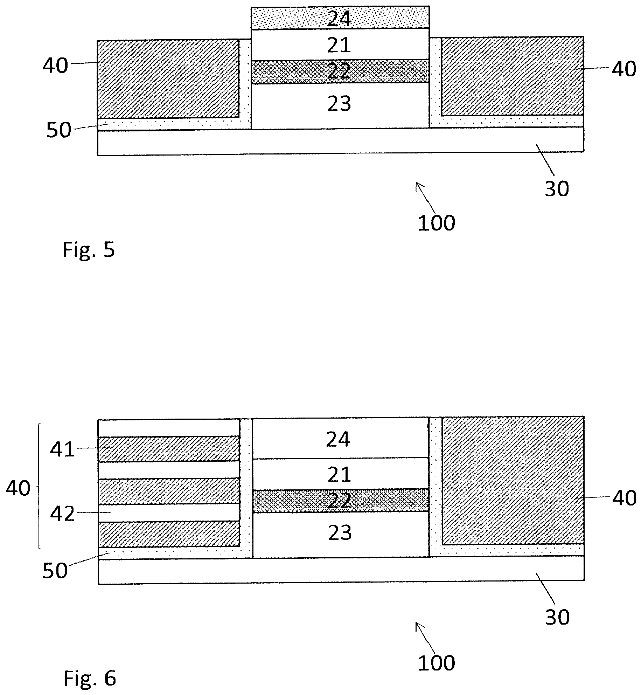

Other configurations of the bias layer 40 are also possible. For example, Fig. 5 shows the MRAM cell 100 whereby the bias layer 40 and the insulating spacer 50 extend along a sidewall portion of the MTJ element 20. The bias layer 40 can have different shapes and positions depending on the required use. In fact, the bias layer 40 can be of any shape as long as it generates a magnetic bias field 61 along the direction of the writing current 31 with a magnitude high enough to tilt the free magnetization 230 as described above.

In yet another embodiment represented in Fig. 6, the bias layer 40 can comprise a stack including several layers of magnetic 41 and non magnetic material 42. For example, the bias layer 40 can comprise a SAF structure or an antiferromagnet.

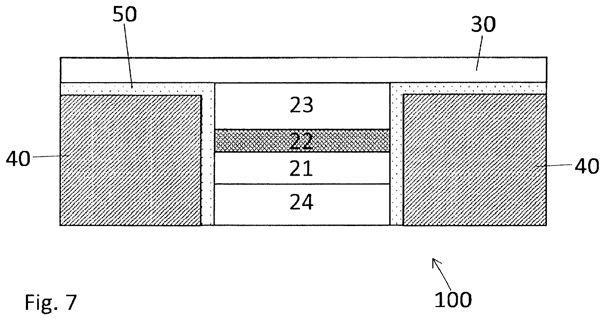

As shown in **Fig. 7****,** configurations of Figs. 1 to 6 can be reversed, whereby the MRAM cell 100 comprises the current layer 30, second ferromagnetic layer 23, tunnel barrier layer 22, first ferromagnetic layer 21, in this order.

In one aspect not represented, a plurality of the MRAM cell 100 can be connected in an array structure to form a magnetic memory.

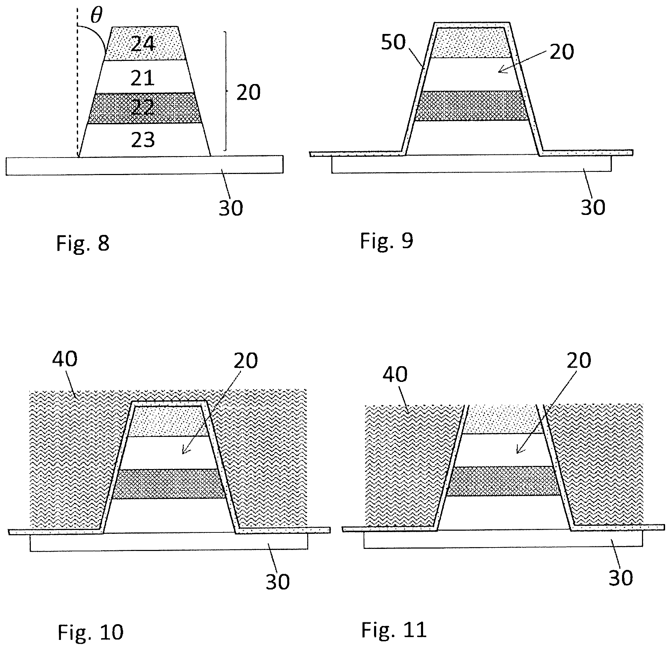

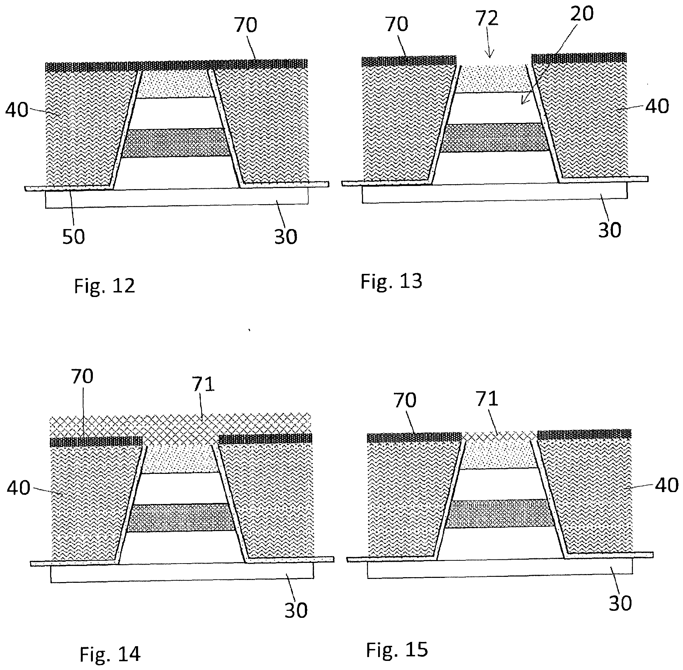

A method for manufacturing the MRAM cell 100 is illustrated in **Figs. 8** to 15. The method can comprise the steps of:
forming the current layer 30 and forming the MTJ element 20 comprising the first ferromagnetic layer 21, tunnel barrier layer 22, second ferromagnetic layer 23 and a capping layer 24 (**Fig**. **8**);
forming the insulating spacer 50 such as to cover the current layer 30 and the MTJ element 20 (**Fig. 9**);
forming the bias layer 40 over the insulating spacer 50 (**Fig. 10**);
exposing at least a portion of the capping layer 24 (**Fig. 11**); and providing an electrical connector on the exposed portion of the capping layer 24 (**Fig. 12 to 15**).

In Fig. 8, the sidewalls of the MTJ element 20 is shown with a tapered shape forming an angle θ. However, the MTJ element 20 can be formed with substantially parallel sidewalls (θ ≈ 0).

The step of forming the insulating spacer 50 can be performed by depositing an insulating material such as SiN, AlO₂, HFO₂, Al₂O₃. The insulating spacer 50 can be formed conformally on the MTJ element 20 and also on the current layer 30 (as shown in Fig. 10). In the example of Fig. 10, the insulating spacer 50 conformally encapsulates the sidewalls of the MTJ element 20 as well as the top capping layer 24.

The bias layer 40 can be formed over the insulating spacer 50 with a thickness that is greater than the one of the MTJ element 20. The step of forming the bias layer 40 can be performed by depositing a magnetic material such as Co, Fe, CoFe, Ni, NiFe, CoNi, CoPt, CoCrPt, CoCrTa or CoSm. It is understood that the bias layer 40 can be formed with a thickness inferior to height of the MTJ element 20.

The step of exposing capping layer 24 can comprise removing a portion of the bias layer 40 and the insulating spacer 50 covering the top of the MTJ element 20 such that to open the capping layer 24. This step can be performed by using a chemical mechanical polishing (CMP) or planarization step or by using an etching step, until the capping layer 24 is reached (see Fig. 11).

In one aspect, providing an electrical connector on the capping layer 24 can comprise the steps of:
forming an insulating layer 70 over the top surface of the bias layer 40 and capping layer 24(see **Fig. 12**).
removing the insulating layer 70 selectively over the capping layer 24 to open a recess 72 in the insulating layer 70 and expose at least a portion of the capping layer 24 (see **Fig. 13**);
forming an electrically conductive layer 71 on top of the remaining insulating layer 70 and exposed portion of the capping layer 24 (see **Fig. 14**).

Providing an electrical connector on the capping layer 24 can further comprise a step of planarizing the formed electrically conductive layer 71 (**Fig. 15**).

The selective removing of the insulating layer 70 can be performed by using a lithographic technique and selective etching. For example, a photolithographic mask can be patterned and used to etch the recess 72 in the insulating layer 70, down to the capping layer 24. The etching process may include a reactive ion etch (RIE) process, although other etching processes may be employed.

The electrically conductive layer 71 can be formed by depositing a metallic electrode layer. The optional step of planarizing the electrically conductive layer 71 can be performed by using a CMP or planarization step or by using an etching step, such that the insulating layer 70 encapsulates the top surface of the bias layer 40 and the electrically conductive layer 71 remains only on top of the capping layer 24. The insulating layer 70 prevents electrical contact between the conducting layer 71 and the bias layer 40, to e.g. lower the connection capacitance otherwise appearing across the insulating spacer 50.

### Reference numbers and symbols

- 100: MRAM cell
- 20: MTJ element
- 21: first ferromagnetic layer
- 210: fixed magnetization
- 22: tunnel barrier layer
- 23: second ferromagnetic layer
- 230: free magnetization
- 24: capping layer
- 30: current layer
- 31: writing current
- 40: bias layer
- 41: magnetic material
- 42: non magnetic material
- 50: insulating spacer
- 61: magnetic bias field
- 70: insulating layer
- 71: electrically conductive layer
- 72: recess

## Claims

1. A magnetic random access memory (MRAM) cell (100), comprising:
a magnetic tunnel junction (MTJ) element (20) comprising a first ferromagnetic layer (21) having a fixed magnetization (210), a tunnel barrier layer (22) and a second ferromagnetic layer (23) having a free magnetization (230), the first and second ferromagnetic layers (21, 23) having an anisotropy perpendicular to the plane of the ferromagnetic layers (21, 23);
a current layer (30) extending substantially parallel to the plane of the second ferromagnetic layer (23) and configured for passing a writing current (31) for switching the free magnetization (230) by a spin orbit torque (SOT) interaction;
**characterized in that**
the MRAM cell comprises a bias layer (40) configured to generate a magnetic bias field (61) interacting with the free magnetization (230), the magnetic bias field (61) having at least a component along the direction of the writing current (31) such as to deterministically switch the free magnetization (230) from a first to a second magnetization state when the writing current (31) is passed; and
**in that** a non-magnetic, electrically insulating layer (50) between the bias layer (40) and the MTJ element (20), the insulating layer (50) comprising a solid phase material having a resistivity above 5 x 10⁻⁵ Ω m and having a thickness between 0.5 and 50 nm such that direct exchange coupling between the second magnetization (230) and the bias layer (40) is prevented.

2. The MRAM cell, according to claim 1,
wherein a thickness of the insulating layer (50) is between 5 and 20 nm or between 1 and 15 nm.

3. The MRAM cell, according to claim 1 or 2,
wherein the spacer (50) has a thermal conductivity greater than 0.3 W/(m·K).

4. The MRAM cell, according to any one of claims 1 to 3,
wherein the insulating layer (50) comprises SiN, AlO₂, HFO₂, Al₂O₃.

5. The MRAM cell, according to any one of claims 1 to 4,
wherein the bias layer (40) extends along at least a sidewall portion of the MTJ element (20).

6. The MRAM cell, according to claim 5,
wherein the bias layer (40) extends on one side of the MTJ element (20).

7. The MRAM cell, according to claim 5,
wherein the bias layer (40) extends on two substantially opposite sides of the MTJ element (20).

8. The MRAM cell, according to claim 5,
wherein the bias layer (40) extends around the perimeter of the MTJ element (20).

9. The MRAM cell, according to any one of claims 5 to 8,
wherein the height of the bias layer (40) is equal or greater than the thickness of the second ferromagnetic layer (23).

10. MRAM cell, according to any one of claims 5 to 8,
wherein the height of the bias layer (40) corresponds substantially to the thickness of the MTJ element (20).

11. The MRAM cell, according to any one of claims 1 to 10,
wherein the insulating layer (50) is further between the bias layer (40) and the current layer (30).

12. A magnetic memory comprising a plurality of the MRAM cell (100) according to any one of claims 1 to 11, connected in an array structure.

13. A method for manufacturing the MRAM cell according to any one of claims 1 to 11, comprising:
forming the current layer (30) and forming the MTJ element (20) comprising the first ferromagnetic layer (21), tunnel barrier layer (22), second ferromagnetic layer (23) and a capping layer (24);
forming the insulating layer (50) such as to cover the current layer (30) and the MTJ element (20);
forming the bias layer (40) over the insulating layer (50);
exposing at least a portion of the capping layer (24); and
providing an electrical connector on the exposed portion of the capping layer (24).

14. The method according to claim 13,
wherein providing an electrical connector on the capping layer (24) comprises the steps of:
forming an insulating layer (70) over a planarized top surface of the bias layer (40) and capping layer (24);
removing the insulating layer (70) selectively over the capping layer (24) to open a recess (72) in the insulating layer (70) and expose at least a portion of the capping layer (24);
forming an electrically conductive layer (71) on top of the remaining insulating layer (70) and exposed portion of the capping layer (24).

15. The method according to claim 14,
further comprising planarizing the formed electrically conductive layer (71).
